**Europäisches Patentamt**

**European Patent Office**

**Office européen des brevets**

(11) Veröffentlichungsnummer: **0 155 059**
A2

(12) # EUROPÄISCHE PATENTANMELDUNG

(21) Anmeldenummer: **85200352.4**

(51) Int. Cl.⁴: **H 03 K 17/64**

(22) Anmeldetag: **11.03.85**

(30) Priorität: **15.03.84 DE 3409423**

(71) Anmelder: **Philips Patentverwaltung GmbH, Billstrasse 80, D-2000 Hamburg 28 (DE)**

(84) Benannte Vertragsstaaten: **DE**

(71) Anmelder: **N.V. Philips' Gloellampenfabrieken, Groenewoudseweg 1, NL-5621 BA Eindhoven (NL)**

(84) Benannte Vertragsstaaten: **BE FR GB NL AT**

(43) Veröffentlichungstag der Anmeldung: **18.09.85**
**Patentblatt 85/38**

(72) Erfinder: **Raets, Hubert, Exdel 32, NL-6391 AJ Nieuwenhagen (NL)**

(74) Vertreter: **Hartmann, Heinrich, Dipl.-Ing. et al, Philips Patentverwaltung GmbH Billstrasse 80 Postfach 10 51 49, D-2000 Hamburg 28 (DE)**

(84) Benannte Vertragsstaaten: **AT BE DE FR GB NL**

(54) **Schaltungsanordnung zum Schalten des Stromes in einer induktiven Last.**

(57) Die vorliegende Erfindung bezieht sich auf eine Schaltungsanordnung zum Schalten eines Stromes in einer induktiven Last mit wenigstens einem Transistor, der mit seiner Kollektor-Emitter-Strecke den Strom in der Last schaltet und dessen Basis mit dem Emitter über ein spannungsstabilisierendes Element zum Stablisieren eines Wertes einer der Basis zugeleiteten Spannung gekoppelt ist, sowie mit einer Ableitanordnung zum Ableiten von entgegen der Leitungsrichtung des Transistors auftretenden Strömen bzw. Spannungen. Für eine derartige Schaltungsanordnung wird eine Verringerung des Schaltungsaufwandes und damit eine Verbilligung der Schaltung dadurch erreicht, dass das spannungsstabilisierende Element auch als Ableitanordnung dient.

Schaltungsanordnung zum Schalten des Stromes in einer induktiven Last

Die Erfindung bezieht sich auf eine Schaltungsanordnung zum Schalten eines Stromes in einer Last, die einen induktiven Blindwiderstand enthält mit wenigstens einem Transistor, der mit seiner Kollektor-Emitter-Strecke den Strom in der Last schaltet und dessen Basis mit dem Emitter über ein spannungsstabilisierendes Element zum Stabilisieren eines Wertes einer der Basis zugeleiteten Spannung gekoppelt ist, sowie mit einer Ableitanordnung zum Ableiten von entgegen der Leitungsrichtung des Transistors auftretenden, durch den induktiven Blindwiderstand hervorgerufenen Strömen bzw. Spannungen.

Aus dem "International Rectifier Hexfet Databook" HDB-2, Chapter 12, Application Note 946, Seiten A-111 bis A-122, insbesondere Fig. 11, von 1982, ist eine derartige, einen elektronischen Schalter bildende Schaltungsanordnung mit einem bipolaren Transistor bekannt, durch die der Strom in einer Last geschaltet wird, die aus einer Reihenschaltung aus einer Induktivität und einem Kondensator besteht. Der Strom in der Last fließt dabei durch die Kollektor-Emitter-Strecke des bipolaren Transistors, dessen Basis eine Schaltspannung zugeleitet wird, die in einer Treiberschaltung erzeugt wird. Zur Stabilisierung des Wertes dieser Schaltspannung im gesperrten Zustand des bipolaren Transistors ist die Basis über eine Zenerdiode mit dem Emitter des bipolaren Transistors gekoppelt.

Bei der bekannten Schaltungsanordnung ist ferner in den Weg des Stromes durch die Last, d.h. in Reihe mit der Kollektor-Emitter-Strecke des bipolaren Transistors, der Hauptstromweg eines Feldeffekttransistors aufgenommen. Der Gate-Elektrode dieses Feldeffekttransistors wird von einer Kontrollschaltung eine Steuerspannung zum Steuern des Stromes in der Last zugeführt. Die Kontrollschaltung liefert dann nur den sehr geringen Gate-Strom des Feldeffekttransistors. Dadurch wird eine unmittelbare Ansteuerung des elektronischen Schalters durch logische Schaltkreise ermöglicht.

Beim Abschalten des Stromes in einer induktiven Last entstehen durch Selbstinduktion Spannungsspitzen bzw. Überschwinger, insbesondere solche, die der Richtung des im leitenden Zustand durch den elektronischen Schalter fließenden Stromes bzw. der in seinem gesperrten Zustand nach dem Abklingen von Schaltvorgängen an ihm anliegenden Spannung entgegengesetzt gerichtet sind. Diese Spannungsspitzen können sehr schnell zu einer Zerstörung des Transistors führen. Sie werden daher über eine Ableitanordnung, vorzugsweise eine Rückschlagdiode, abgeleitet, die parallel zur Reihenschaltung der Kollektor-Emitter-Strecke des bipolaren Transistors mit dem Hauptstromweg des Feldeffekttransistors derart gepolt angeordnet ist, daß sie für die im gesperrten Zustand des Transistors zwischen dessen Kollektor und Emitter nach Abklingen von Schaltvorgängen anliegende Spannung gesperrt bleibt. In Schaltungsanordnungen zum Schalten hoher Spannungen an eine Last mit hohem induktivem Blindwiderstand muß diese Diode einerseits eine hohe Sperrspannung aufweisen und andererseits für einen hohen Spitzenstrom ausgelegt sein. Derartige Dioden sind relativ teuer.

Die Erfindung hat die Aufgabe, eine Schaltungsanordnung der eingangs genannten Art dahingehend zu vereinfachen, daß der Einsatz einer gesonderten, teuren Ableitanordnung entbehrlich ist, ohne den Schutz des Transistors gegen Spannungsspitzen zu vermindern.

0155059

Diese Aufgabe wird erfindungsgemäß dadurch gelöst, daß das spannungsstabilisierende Element auch als Ableitanordnung dient.

Bei der erfindungsgemäßen Schaltungsanordnung wird somit das spannungsstabilisierende Element in vorteilhafter Weise doppelt ausgenutzt, d.h. es dient außer zum Stabilisieren der Schaltspannung an der Basis des Transistors zusätzlich zum Ableiten von Spannungsspitzen bzw. Überschwingern, insbesondere beim Umschalten des Transistors in den gesperrten Zustand. Die entgegen der Leitungsrichtung des Transistors fließenden Ströme werden nur durch das spannungsstabilisierende Element und die Kollektor-Basis-Strecke des Transistors abgeleitet. Die gesonderte Ableitanordnung, insbesondere Rückschlagdiode, parallel zur Kollektor-Emitter-Strecke des Transistors kann dann damit entfallen. Das spannungsstabilisierende Element muß bei der erfindungsgemäßen Schaltungsanordnung lediglich für die Spannungs- bzw. Stromspitzen oder Überschwinger ausgelegt werden. Dies ist jedoch wesentlich einfacher und kostengünstiger als eine zusätzliche, von dem spannungsstabilisierenden Element getrennte Ableitanordnung.

Eine besonders einfache Schaltungsanordnung wird nach einer Weiterbildung der Erfindung dadurch erhalten, daß das spannungsstabilisierende Element eine Zenerdiode umfaßt. Diese Zenerdiode stabilisiert, in Sperrichtung gepolt, die Spannung an der Basis des Transistors, und bildet unmittelbar bei Polung in Durchlaßrichtung gemeinsam mit der Kollektor-Basis-Strecke des Transistors eine Ableitanordnung für entgegen der Leitungsrichtung des Transistors auftretende Spannungsspitzen bzw. Überschwinger. Die Zenerdiode ist derart ausgelegt, daß sie in Durchlaßrichtung den maximalen Wert der Ströme leiten kann, die durch die Spannungsspitzen bzw. Überschwinger hervorgerufen werden.

Der Vollständigkeit halber sei an dieser Stelle bemerkt, daß es aus "IEEE J. Solid-State Circuits", Vol. SC-16, Nr. 2 vom April 1981, Seiten 62 bis 65, bekannt ist, bei einem bipolaren Transistor, der einen Strom in einer induktiven Last, insbesondere einem Schwingkreis, schaltet, parallel zur Basis-Emitter-Strecke eine Rückschlagdiode derart anzuordnen, daß ihre Kathode mit der Basis und ihre Anode mit dem Emitter des (npn-) Transistors verbunden ist. Diese Rückschlagdiode bildet einen Begrenzer während der nach Umschalten des Transistors in den gesperrten Zustand an der induktiven Last auftretenden negativen Halbwelle. Bei dieser Schaltungsanordnung ist jedoch kein spannungsstabilisierendes Element zum Stabilisieren der Spannung an der Basis des Transistors oder an einer anderen Stelle der Schaltungsanordnung vorgesehen.

Zwei Ausführungsbeispiele der Erfindung sind in der Zeichnung dargestellt und werden im nachfolgenden näher beschrieben. Es zeigen

Fig. 1 ein erstes Beispiel für eine Schaltungsanordnung nach der Erfindung in vereinfachter Darstellung,

Fig. 2 ein zweites Ausführungsbeispiel für eine Schaltungsanordnung gemäß der Erfindung und

Fig. 3 eine Schaltungsanordnung gemäß der Erfindung, wobei die Last eine Entladungslampe ist.

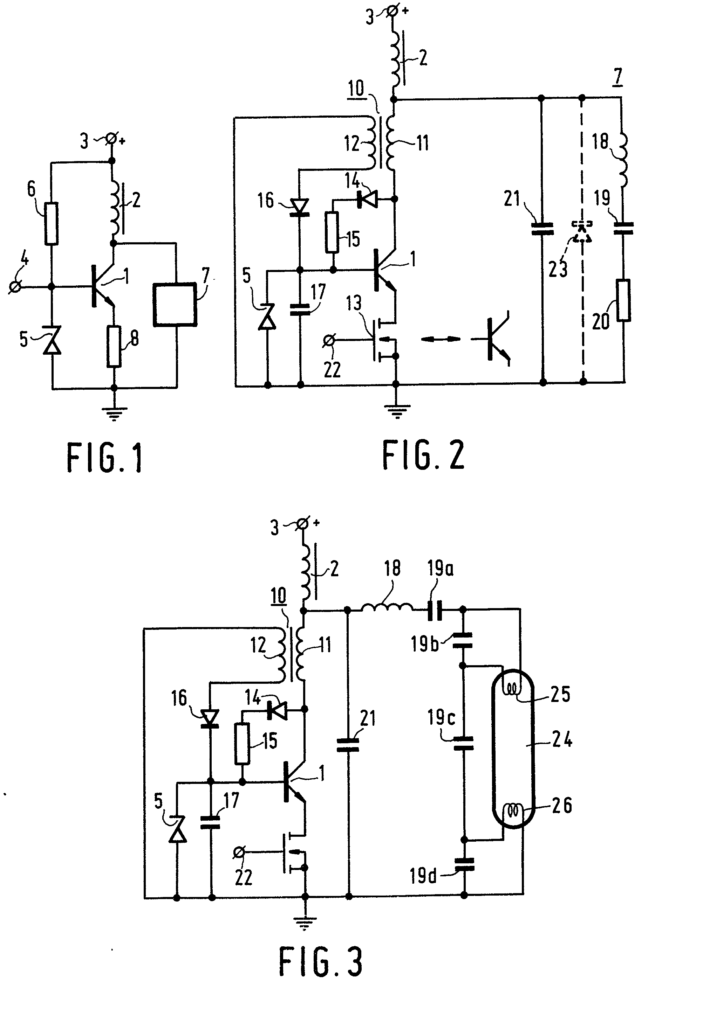

Fig. 1 zeigt ein schematisches Schaltbild für ein einfaches Ausführungsbeispiel einer Schaltungsanordnung gemäß der Erfindung. Darin ist 1 ein bipolarer Transistor, dessen Kollektor über eine Speisespule 2 mit dem positiven Pol 3 einer Gleichspannungsquelle verbunden ist. Die Basis des Transistors 1 ist mit einem Eingangsanschluß 4 zum Zuführen eines Schaltsignals verbunden, durch das der Transistor wechselweise in den leitenden oder in den gesperrten Zustand geschaltet ist. Der Eingangsanschluß 4 ist weiterhin mit der Kathode einer Zenerdiode 5 und mit einem ersten Anschluß eines Vorwiderstandes 6 verbunden. Die Zenerdiode 5 bildet ein spannungsstabilisierendes Element. Ihre Anode ist mit Masse verbunden, woran auch der Emitter des Transistors 1 über einen Emitterwiderstand 8 angeschlossen ist. Zusammen mit dem Vorwiderstand 6, dessen zweiter Anschluß an den positiven Pol 3 der Gleichspannungsquelle geführt ist, wird am Eingangsanschluß 4 und damit an der Basis des Transistors 1 ein Maximalwert einer Gleichvorspannung vorgegeben. Dieser wird das über den Eingangsanschluß 4 zugeführte Schaltsignal überlagert.

Mit dem Kollektor und dem Emitter des Transistors 1 ist jeweils ein Pol einer Last 7 verbunden, die einen induktiven Blindwiderstand enthält. Dies ist in der Fig. 1 mit dem halb als ohmschen Widerstand, halb als Induktivität dargestellten Impedanzsymbol angedeutet. Die Last 7 kann einen Serienkondensator enthalten, der einen Gleichstrom vom positiven Pol 3 der Gleichspannungsquelle über die Speisespule 2 durch die Last 7 zur Masse unterbindet.

Durch die über die Ströme in den Induktivitäten der Speisespule 2 und der Last 7 gespeicherten Energien können Spannungsspitzen bzw. Überschwinger auftreten, durch die am Kollektor des Transistors 1 eine gegenüber Masse negative Spannung hervorgerufen wird. Derartige negative Spannungsspitzen werden nun bei der vorliegenden Schaltungsanordnung ohne den Einsatz zusätzlicher Bauelemente vorteilhaft über die Zenerdiode 5 und die Basis-Kollektor-Strecke des Transistors 1 abgeleitet. Die Zenerdiode, die

0155059

in ihrer Rückwärtsrichtung gepolt ein spannungsstabilisierendes Element bildet, stellt sich in Vorwärtsrichtung gepolt als Diode dar. Dadurch wird eine Beschädigung der Bauelemente der Schaltungsanordnung vermieden.

Eine noch einfachere Schaltungsanordnung erhält man durch Entfernen der Last 7 in Fig. 1. Die Speisespule 2 wirkt dann als Belastungsimpedanz mit induktivem Blindwiderstand, durch den ebenfalls negative Spannungsspitzen bzw. Überschwinger hervorgerufen werden können, die durch die Zenerdiode 5 und die Kollektor-Basis-Strecke des Transistors 1 abgeleitet werden.

Fig. 2 zeigt ein etwas detaillierteres Schaltbild einer weiteren Ausführungsform der Erfindung. In dieser Schaltungsanordnung ist die Kollektor-Emitter-Strecke des bipolaren Transistors 1 in Reihe geschaltet mit einer Primärwicklung 11 eines Transformators 10, der Speisespule 2 sowie dem Hauptstromweg eines Schaltelementes 13. Als solches wird bevorzugt ein Feldeffekttransistor eingesetzt, dessen Hauptstromweg die Source-Drain-Strecke bildet, oder auch ein zweiter bipolarer Transistor, dessen Hauptstromweg die Kollektor-Emitter-Strecke ist. Es können jedoch auch andere Arten von Schaltelementen zum Einsatz kommen, wie beispielsweise Tyristoren und dergl.

Die Schaltungsanordnung gemäß Fig. 2 weist weiterhin eine Reihenschaltung aus einer ersten Diode 14 und einem Widerstand 15 auf. Die Anode der ersten Diode 14 ist mit dem Kollektor des bipolaren Transistors 1, die Kathode der ersten Diode 14 über den Widerstand 15 mit der Basis des bipolaren Transistors 1 verbunden. Mit der Basis des Transistors 1 ist weiterhin die Kathode einer zweiten Diode 16, deren Anode mit einem Anschluß der Sekundärwicklung 12 des Transformators 10 verbunden ist, sowie ein Anschluß eines Kondensators 17 und die Kathode der Zenerdiode 5 verbunden. Der zweite Anschluß des Kondensators 17
sowie die Anode der Zenerdiode 5 und der zweite Anschluß
der Sekundärwicklung 12 des Transformators 10 liegen an
Masse.

Die Last 7 besteht bei dem vorliegenden Ausführungsbeispiel aus einer Reihenschaltung einer Lastinduktivität 18,
eines Lastkondensators 19 und eines Lastwiderstandes 20,
die parallel zu einem Parallelkondensator 21 geschaltet
ist. Ein Pol dieser Parallelschaltung ist mit dem Verbindungspunkt zwischen der Primärwicklung 11 des Transformators 10 und der Speisespule 2 verbunden, während ein
zweiter Pol der Parallelschaltung gemeinsam mit dem dem
bipolaren Transistor 1 abgewandten Ende des Hauptstromweges des Schaltelementes 13 an Masse liegt. Der dem
Transformator 10 abgewandte Anschluß der Speisespule 2 ist
wiederum mit dem positiven Pol der Gleichspannungsquelle
verbunden.

Befindet sich nun der bipolare Transistor 1 im gesperrten
Zustand, fließt einerseits vom positiven Pol 3 der Gleichspannungsquelle über die Speisespule 2 ein Strom in die
Last 7 und andererseits ein - in der Regel wesentlich
kleinerer - Strom über die Primärwicklung 11 des Transformators 10, die erste Diode 14 und den Widerstand 15 zum
Kondensator 17 und lädt diesen auf die durch die Zenerdiode 5 vorgegebene maximale Vorspannung für die Basis des
bipolaren Transistors 1 auf. Das Schaltelement 13,
beispielsweise ein Feldeffekttransistor, ist ebenfalls
gesperrt.

Zum Umschalten des bipolaren Transistors 1 wird nun dem
Schaltelement 13 über einen Steueranschluß 22, der im vorliegenden Fall mit der Gate-Elektrode des Feldeffekttransistors verbunden ist, ein Steuersignal zugeleitet. Der Feldeffekttransistor 13 wird leitend, das Potential am Emitter des bipolaren Transistors 1 wird gegenüber der durch die Zenerdiode 5 festgelegten Vorspannung an der Basis so weit verringert, daß der bipolare Transistor 1 in den leitenden Zustand umgeschaltet wird. Der Kondensator 17 entlädt sich daraufhin sehr rasch über die Basis-Emitter-Strecke des bipolaren Transistors 1 und beschleunigt das Umschalten. Durch den Anstieg des Stromes in der Kollektor-Emitter-Strecke des bipolaren Transistors 1 wird außerdem in der Sekundärwicklung 12 des Transformators 10 eine Spannung erzeugt, durch die über die zweite Diode 16 dem Kondensator 17 und damit der Basis weiterer, den leitenden Zustand des bipolaren Transistors 1 aufrechterhaltender Strom zugeführt wird.

Der Strom durch die Kollektor-Emitter-Strecke des bipolaren Transistors 1 und die Speisespule 2 steigt kontinuierlich an, bis der Feldeffekttransistor 13 durch ein Steuersignal am Steueranschluß 22 in den gesperrten Zustand geschaltet wird. Der aufgrund der Selbstinduktion in der Speisespule 2 weiterfließende Strom fließt dann durch die Last 7, der dadurch die in der Speisespule 2 bis dahin gespeicherte Energie zugeleitet wird. Gleichzeitig beginnt sich der Kondensator 17 wieder über die Primärwicklung 11 sowie die erste Diode 14 und den Widerstand 15 aufzuladen.

Die Last 7 in der vorliegenden Schaltungsanordnung bildet einen Schwingkreis, der durch Zufuhr der Energie aus der Speisespule 2 zum Schwingen angeregt wird. Dabei kann der mit dem Transformator 10 und der Speisespule 2 verbundene Pol der Last gegenüber Masse eine negative Spannung annehmen. Diese negativen Spannungsspitzen bzw. Überschwinger werden bei der Schaltungsanordnung nach dem vorliegenden Ausführungsbeispiel erfindungsgemäß über die Zenerdiode 5 und die Basis-Kollektor-Strecke des bipolaren Transistors 1 (sowie die Primärwicklung 11 des Transformators 10) abgeleitet. Zum Vergleich ist gestrichelt eine Rückschlagdiode 23 eingezeichnet, wie sie bei den bisher bekannten Schaltungsanordnungen zum Ableiten der Spannungsspitzen bzw. Überschwinger erforderlich war und die bei der erfindungsgemäßen Schaltungsanordnung eingespart wird.

In Fig. 3 sind die gleichen Teile wie in Fig. 2 mit denselben Bezugszeichen versehen. Die Last ist hier eine rohrförmige Niederdruckquecksilberdampfentladungslampe 24 (in einer praktischen Ausführungsform mit einer Leistung von etwa 15 W). An den Enden der Lampe sind die Elektroden 25 und 26 angeordnet, zwischen denen im Betrieb eine Entladung aufrechterhalten wird. Die Schaltung arbeitet als Wechselrichter für die Lampe. Damit eine Zündung der Lampe bei kalten Elektroden vermieden wird, sind in einer Reihenschaltung neben der Lastinduktivität 18 die Kondensatoren 19a, 19b, 19c und 19d aufgenommen. Die Elektroden der Lampe sind zum Kondensator 19b bzw. zum Kondensator 19d parallel geschaltet.

In einem konkreten Ausführungsbeispiel haben die Schaltungselemente nach Fig. 3 gemäß nachstehender Tabelle die Werte:

| | | | |
|---|---|---|---|
| Widerstand 15 | | 1 | MOhm |
| Kondensator 17 | | 2,7 | nF |
| " | 21 | 290 | pF |
| " | 19a | 495 | pF |
| " | 19b | 15 | nF |
| " | 19c | 804 | pF |
| " | 19d | 15 | nF |
| Lastinduktivität 2 | | 6,6 | mH |
| " | 18 | 0,52 | mH |

Die Frequenz dieser Anordnung im Betrieb der Lampe beträgt etwa 400 kHz.

PATENTANSPRÜCHE

1. Schaltungsanordnung zum Schalten eines Stromes in einer Last, die einen induktiven Blindwiderstand enthält, mit wenigstens einem Transistor, der mit seiner Kollektor-Emitter-Strecke den Strom in der Last schaltet und dessen Basis mit dem Emitter über ein spannungsstabilisierendes Element zum Stabilisieren eines Wertes einer der Basis zugeleiteten Spannung gekoppelt ist, sowie mit einer Ableitanordnung zum Ableiten von entgegen der Leitungsrichtung des Transistors auftretenden, durch den induktiven Blindwiderstand hervorgerufenen Strömen bzw. Spannungen, dadurch gekennzeichnet, daß das spannungsstabilisierende Element auch als Ableitanordnung dient.

2. Schaltungsanordnung nach Anspruch 1, dadurch gekennzeichnet, daß das spannungsstabilisierende Element eine Zenerdiode umfaßt.

3. Schaltungsanordnung nach Anspruch 1 oder 2, dadurch gekennzeichnet, daß die Last eine Entladungslampe ist.

FIG.1

FIG.2

FIG.3

PHD 84-042